Europäisches Patentamt

European Patent Office

Office européen des brevets

(11) Veröffentlichungsnummer: **0 216 264**
**A1**

## (12) EUROPÄISCHE PATENTANMELDUNG

(21) Anmeldenummer: 86112571.4

(22) Anmeldetag: 11.09.86

(51) Int. Cl.⁴: **G11C 11/40**

(30) Priorität: **19.09.85 DE 3533453**

(43) Veröffentlichungstag der Anmeldung:
**01.04.87 Patentblatt 87/14**

(84) Benannte Vertragsstaaten:
**AT BE CH DE FR GB IT LI NL SE**

(71) Anmelder: **Siemens Aktiengesellschaft Berlin
und München
Wittelsbacherplatz 2
D-8000 München 2(DE)**

(72) Erfinder: **Barré, Claude, Dipl.-Ing.
Implerstrasse 23
D-8000 München 70(DE)**

(54) Schaltungsanordnung zur Schreib-Lese-Steuerung in einem ECL-Speicher.

(57) In größeren ECL-Speichern ist der Schreib-Lese-Strom auf den Bitleitungen wesentlich größer als der durch eine Speicherstelle fließende Strom. Damit wird im Lesemodus einer der beiden überkreuz gekoppelten Transistoren (T1, T2) der Speicherzelle in das Sättigungsgebiet gesteuert. Zum Wechseln des Zelleninhalts bei einem anschließenden Schreibzugriff muß der gesättigte Transistor umgeladen werden. Das verursacht eine Verlängerung der Schreibzeit.

Um die Sättigung unschädlich zu machen, wird bei jedem auf einen Lesezugriff folgenden Schreibzugriff vor dem eigentlichen Schreibvorgang ein "neutraler Zustand" erzeugt, bei dem an beide in den Bitleitungen (BL1, BL2) liegenden Schreib-Lese-Transistoren (T3, T4) eine Steuerspannung mit dem höheren Binärwert angelegt wird.

FIG 1

## Schaltungsanordnung zur Schreib-Lese-Steuerung in einem ECL-Speicher

Die Erfindung bezieht sich auf eine Schaltungsanordnung zur Schreib-Lese-Steuerung in einem ECL-Speicher nach dem Oberbegriff des Patentanspruchs 1.

In ECL-Speichern der genannten Art, bei denen in jeder Spalte beispielsweise 16 Speicherzellen oder ein Vielfaches davon angeordnet sind, ist der Schreib-Lese-Strom auf den Bitleitungen größer als der Zellenstrom. Das hat zur Folge, daß in Lesemodus des Speichers einer der beiden überkreuz gekoppelten Transistoren der adressierten Speicherzelle in den Sättigungszustand gerät. Soll bei einem anschließenden Schreibzugriff der Zelleninhalt verändert werden, dann muß der gesättigte Transistor umgeladen werden. Das ergibt eine Verlängerung der Schreibzeit.

Um die Nachteile dieser Sättigung in Grenzen zu halten, muß der Herstellungsprozess mit dem Ziel einer sehr engen Tolerierung der Subtrattransistor-Stromverstärkung außerordentlich genau gesteuert werden.

Der Erfindung liegt die Aufgabe zugrunde, die störende Wirkung der erwähnten Sättigung durch - schaltungstechnische Maßnahmen, d.h. durch eine entsprechende Ausbildung der Schaltungsanordnung zur Schreib-Lese-Steuerung zu eliminieren. Diese Aufgabe wird durch die Merkmale im kennzeichnenden Teil des Patentanspruchs 1 gelöst.

Im folgenden wird die Erfindung anhand der Zeichnung näher erläutert. Es zeigt darin:

FIG 1 eine Spalte der Speicherzellenmatrix,

FIG 2 ein vorteilhaftes Ausführungsbeispiel einer Schaltungsanordnung zur Schreib-Lese-Steuerung gemäß der Erfindung und

FIG 3 ein Zeitdiagramm.

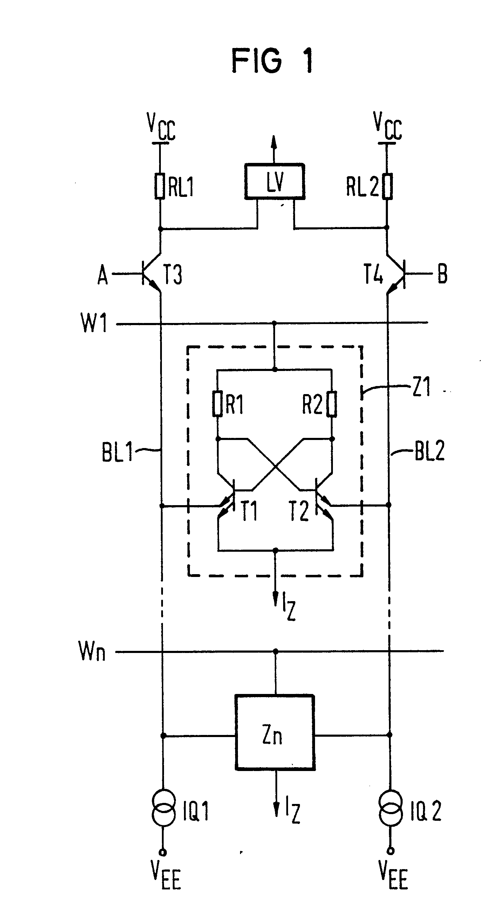

Die in FIG 1 dargestellte Spalte einer Speicherzellenmatrix enthält zwei Speicherzellen $Z1$ und $Zn$ stellvertretend für eine wesentlich größere Zahl von Speicherzellen, z.B. 16, 32 oder mehr. Entsprechend der Darstellung der Speicherzelle $Z1$ besteht jede Zelle aus zwei Doppelemittertransistoren $T1$ und $T2$, die durch gegenseitige Verbindungen des Kollektors des einen Transistors mit der Basis des anderen Transistors überkreuz gekoppelt sind. In die Verbindung der ersten Emitter beider Transistoren $T1$ und $T2$ wird ein konstanter Zellenstrom $I_z$ eingespeist. Die zweiten Emitter sind an eine erste bzw. zweite Bitleitung $BL1$ bzw. $BL2$ angeschlossen. Die Kollektoren der Transisotren $T1$ und $T2$ sind über Kollektorwiderstände $R1$ und $R2$ mit Wortauswahlleitungen (Wortleitungen) $W1$ bzw. $Wn$ verbunden, die im allgemeinen für einander entsprechende Speicherzellen in mehreren Spalten gemeinsam vorgesehen sind. Häufig sind den Kollektorwiderständen Dioden in Durchlaßrichtung parallel geschaltet.

Die Wortleitungen werden durch einen nicht dargestellten Wortauswahldecoder so angesteuert, daß eine und nur eine Wortleitung ein höheres Potential aufweist, während alle anderen auf einem tieferen Potential liegen.

Die Bitleitungen $BL1$ bzw. $BL2$ sind mit Konstantstromquellen $IQ1$ bzw. $IQ2$ verbunden und an den anderen Enden durch Lesewiderstände $RL1$ bzw. $RL2$ abgeschlossen, an denen beim Lesen des Inhalts der ausgewählten Speicherzelle unterschiedliche Spannungsabfälle auftreten, die durch einen Leseverstärker $LV$ ausgewertet werden. Zwischen die Anschlußpunkte für den Leseverstärker $LV$ und die Anschlüsse der Speicherzellen sind in die Bitleitungen $BL1$ und $BL2$ die Emitter-Kollektorstrecken von zwei Transistoren $T3$ und $T4$ eingefügt. Die Transistoren $T3$, $T4$ dienen zur Schreib-Lese-Steuerung und werden über die Anschlußpunkte $A$ bzw. $B$, die den Basisanschlüssen dieser Transistoren entsprechen, angesteuert. Bezeichnet man einen oberen binären Signalpegel an den Anschlußpunkten $A$ oder $B$ mit $H$, einen unteren binären Signalpegel mit $L$ und einen in der Mitte zwischen den Pegeln $H$ und $L$ liegenden Signalpegel mit $M$, dann gilt bei einem Schreibzugriff, abhängig von dem Binärwert des einzuschreibenden Datenbits $D = H \rightarrow A = L$ und $B = H$ bzw. $D = L \rightarrow A = H$ und $B = L$.

Für einen Lesezugriff gilt $A \approx B \approx M$.

Gemäß der Erfindung wird eine weitere Signalkonstellation $A = B = H$ in der Übergansphase zwischen einem abgeschlossenen Lesevorgang und einem folgenden Schreibzugriff erzeugt. Diese Signalkonstellation beginnt zweckmäßig etwa im Zeitpunkt des Adresswechsels und endet erst mit dem Beginn der Eingabe eines Datenbits in die adressierte Speicherzelle, d.h. der Zustand $A = B = H$ geht unmittelbar über in $A = L$, $B = H$ oder $A = H$, $B = L$.

Während in bekannten Speichersteuerungen ein einzelnes binäres Steuersignal $W$ zur Festlegung der Funktionen "Schreiben" oder "Lesen" ausreichend war, ist nun ein Signal $R$ notwendig, um den zusätzlichen neutralen Zustand $A = B = H$ vor jedem Schreibvorgang erzeugen zu können.

Die Abhängigkeit der Signale A und B zur Steuerung der in die Bitleitungen eingefügten Transistoren T3 und T4 von den Steuersignalen W und R und von den Schreibdaten D ist in der nachstehenden Tabelle nochmals übersichtlich dargestellt. Das Zeichen X in der Spalte der Schreibdaten bezeichnet einen beliebigen Binärwert.

| D | W | R | A | B | |
|---|---|---|---|---|---|
| X | L | H | M | M | Lesen |
| H | H | L | L | H | Schreiben H |
| L | H | L | H | L | Schreiben L |
| X | L | L | H | H | neutraler Zustand |

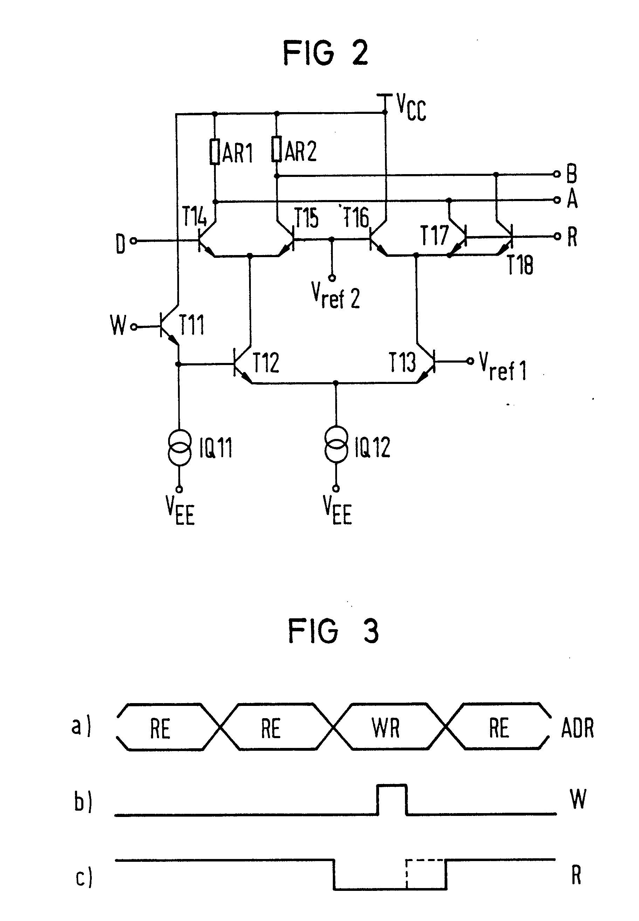

Die FIG 2 zeigt ein vorteilhaftes Ausführungsbeispiel einer Schaltungsanordnung zur Ableitung der Signale A und B für die Steuerung der vorher genannten Transistoren T3 und T4. Die Schaltungsanordnung besitzt einen durch das Steuersignal W über einen Emitterfolger mit dem Transistor T11 und der Konstantstromquelle IQ11 gesteuerten ersten Differenzverstärker mit den emittergekoppelten Transistoren T12 und T13. Der Differenzverstärker wird von einer Konstantstromquelle IQ12 gespeist. Die Basis des Transistors T12 ist mit dem Emitter des Transistors T11 verbunden. Die Basis des Transistors T13 liegt auf einem ersten Referenzpotential $V_{ref1}$.

Mit dem Kollektor des direkt gesteuerten Transistors T12 sind die Emitter von Transistoren T14 und T15 verbunden, die einen zweiten Differenzverstärker bilden. Der zweite Differenzverstärker wird durch das Dateneingabesignal D gesteuert, das an der Basis des Transistors T14 anliegt. Die Basis des Transistors T15 wird auf einem zweiten Referenzpotential $V_{ref2}$ gehalten.

Ein dritter Differenzverstärker mit den emittergekoppelten Transistorn T16, T17 und T18 ist im Kollektorkreis des indirekt gesteuerten Transistors T13 des ersten Differenzverstärkers angeordnet. Die Basis des Transistors T16 liegt auf dem schon genannten zweiten Referenzpotential $V_{ref2}$. Die Transistoren T17 und T18 werden gemeinsam durch das zweite Steuersignal R gesteuert.

Die Kollektoren der Transistoren T14 und T17 sind miteinander und mit einem ersten am Bezugspotential $V_{CC}$ anliegenden Arbeitswiderstand AR1 verbunden. Der Verbindungspunkt bildet den Ausgang für das Signal A. Der Verbindungspunkt der Kollektoren der Transistoren T15 und T18 mit einem zweiten gegen das Bezugspotential $V_{CC}$ geschalteten Arbeitswiderstand AR2 bildet den Ausgang für das Signal B.

Die Wirkungsweise der Schaltungsanordnung nach FIG 2 ist anhand der Zeichnung leicht zu erkennen. Für W = H sind die Signale A und B allein vom Dateneingabesignal D abhängig. Das Steuersignal R hat keinen Einfluß, weil der Transistor T13 im ersten Differenzverstärker stromlos ist (Schreiben).

Dagegen sind die Signale A und B für W = L wegen der Stromlosigkeit des Transistor T12 nur noch vom Steuersignal R abhängig. Mit R = H teilt sich der von der Konstantstromquelle IQ2 gelieferte Strom zu gleichen Teilen auf die beiden Arbeitswiderstände AR1 und AR2 auf und erzeugt in jedem der Widerstände einen Spannungsabfall, der aber nur die Hälfte des typischen Werts beträgt (Lesen). Bei R = L fließt der ganze Strom aus der Konstantstromquelle IQ12 über die Transistoren T13 und T16 und verursacht somit in keinem der Arbeitswiderstände AR1 und AR2 einen Spannungsabfall (neutraler Zustand).

In dem Zeitdiagramm FIG 3 ist in der oberen Reihe a) symbolisch die Eingabe der Speicheradressen ADR dargestellt. Die vier Abschnitte mit parallelen horizontalen Linien kennzeichnen die Zeitbereiche, in denen die Adressen an den Adresseingängen des Speichers gültig sind. In den Zwischenabschnitten mit den schräg verlaufenden, sich überkreuzenden Linien finden Adresswechsel statt. Zur Erleichterung des Verständnisses ist in den einzelnen Feldern eingetragen, ob ein Lesezugriff RE oder ein Schreibzugriff WR erfolgt.

In der mittleren Reihe b) ist der Verlauf des ersten Steuersignals W angegeben. Wie ersichtlich ist, gilt für Lesezugriffe W = L. Nur bei einem Schreibzugriff wird für eine begrenzte Zeit W = H.

Der Verlauf des zweiten Steuersignals R in der dritten Reihe c) zeigt R = H für Lesezugriffe und R = L für Schreibzugriffe und entspricht insoweit der bekannten Bezeihung R = W̄. Wichtig für den vorliegenden Fall ist jedoch, daß der Übergang des zweiten Steuersignals R von H nach L abweichend von der angegebenen Beziehung wesentlich früher erfolgt als der Übergang des ersten Steuersignals W von L nach H, wobei der frühestmögliche Zeitpunkt selbstverständlich erst nach dem Abschluß eines vorausgehenden Lesevorgangs liegen kann. Der zeitliche Abstand der genannten Signalübergänge muß aber ausreichend sein, um den eingangs erwähnten Sättigungszustand eines der beiden gekoppelten Transistoren in der adressierten Speicherzelle abzubauen.

Der Übergang des zweiten Steuersignals R von L nach H kann gleichzeitig mit dem Übergang des ersten Steuersignals W von H nach L oder später erfolgen. Dies ist in FIG 3 durch einen gestrichelten Linienzug angedeutet.

Bezugszeichenliste

A Erstes Ausgangssignal, erster Ausgang

B Zweites Ausgangssignal, zweiter Ausgang

D Dateneingabessignal

W Erstes Schreib-Lese-Steuersignal, erster Steuereingang

R Zweites Schreib-Lese-Steuersignal

RL1 Erster Lesewiderstand

RL2 Zweiter Lesewiderstand

BL1 Erste Bitleitung

BL2 Zweite Bitleitung

W1 Erste Wortauswahlleitung

Wn n-te Wortauswahlleitung

R1 Erster Kollektorwiderstand

R2 Zweiter Kollektorwiderstand

AR1 Erster Arbeitswiderstand

AR2 Zweiter Arbeitswiderstand

Z1 Erste Speicherzelle

Zn n-te Speicherzelle

T1 Erster Transistor

T2 Zweiter Transistor

T3 Erster Transistor für Schreib-Lesesteuerung

T4 Zweiter Transistor für Schreib-Lesesteuerung

T11 Transistor

T12 1. Transistor eines ersten Differenzverstärkers

T23 2. Transistor eines ersten Differenzverstärkers

T14 1. Transistor eines zweiten Differenzverstärkers

T15 2. Transistor eines zweiten Differenzverstärkers

T16 1. Transistor eines dritten Differenzverstärkers

T17 2. Transistor eines dritten Differenzverstärkers

T18 3. Transistor eines dritten Differenzverstärkers

$V_{EE}$ Erstes Bezugspotential

$V_{CC}$ Zweites Bezugspotential

$V_{ref2}$ Erstes Referenzsignal

$V_{ref2}$ Zweites Referenzsignal

IQ1 Erste Konstantstromquelle

IQ1 Zweite Konstantstromquelle

IQ11 Dritte Konstantstromquelle

IQ12 Vierte Konstantstromquelle

$I_Z$ Zellenstrom

LV Leseverstärker

ADR Speicheradressen

RE Lesezugriff

WR Schreibzugriff

**Ansprüche**

1. Schaltungsanordnung zur Schreib-Lese-Steuerung in einem ECL-Speicher mit zeilen-und spaltenweise angeordneten Speicherzellen, wobei jeweils die einer Spalte zugeordneten Speicherzellen gemeinsam mit einem Paar von Bitleitungen verbunden sind, mit einem Dateneingang für ein Dateneingabesignal, mit zwei Ausgängen, die mit den Basisanschlüssen von Schreib-Lese-Transistoren verbunden sind, deren Kollektor-Emitter-Strecken zwischen den Bitleitungen und den die Bitleitungen abschließenden Lesewiderständen eingefügt sind, und mit einem ersten Steuereingang zur Steuerung durch eine erstes Schreib-Lese-Steuersignal, **dadurch gekennzeichnet**, daß ein zweiter Steuereingang (R) zur Steuerung durch ein zweites Schreib-Lese-Steuersignal (R) vorgesehen ist,

daß die Ausgangssingale (A,B) an den Ausgängen (A,B) abhängig von den Steuersignalen (W, R) und dem Dateneingabesignal (D) einen oberen oder unteren Binärwert H bzw. L oder einen Mittelwert M annehmen, wobei gilt:

W = H, R = L, D = H → A = L, B = H

W = H, R = L, D = L → A = H, B = L

W = L, R = H → A ≈ B ≈ M

W = L, R = L → A = B = H

und daß bei einem Wechsel von einem Lesezugriff zu einem Schreibzugriff der Übergang des zweiten Steuersignals R von dem oberen binären Signalwert H auf den unteren binären Signalwert L früher erfolgt als der Übergang des ersten Steuersignals (W) von dem unteren binären Signalwert L auf den oberen binären Signalwert H.

2. Schaltungsdanordnung nach Anspruch 1, **gekennzeichnet** durch

einen ersten, von einer Konstantstromquelle (IQ2) gespeisten Differenzverstärker mit zwei emittergekoppelten Transistoren (T12, T13), wobei die Basis des ersten Transistors (T12) mit dem Emitter eines als Emitterfolger betriebenen, durch das erste Steuersignal (W) gesteuerten Transistors (T11) verbunden ist und die Basis des zweiten Transistors (T13) auf einem ersten Referenzpotential (V$_{ref1}$) liegt,

einen zweiten Differenzverstärker mit zwei Transistoren (T14, T15), deren Emitter gemeinsam mit dem Kollektor des ersten Transistors (T12) im ersten Differenzverstärker und deren Kollektoren mit den Ausgängen (A,B) und über je einen Arbeitswiderstand (AR1, AR2) mit dem Bezugspotential (V$_{CC}$) verbunden sind, wobei an der Basis des einen Transistors (T14) das Dateneingabesignal (D) anliegt und die Basis des anderen Transistors (T15) auf einem zweiten Referenzpotential (V$_{ref2}$) gehalten ist, einen dritten Differenzverstärker mit 3 Transistoren (T16, T17, T18), deren Emitter gemeinsam mit dem Kollektor des zweiten Transistors (T13) im ersten Differenzverstärker verbunden sind, wobei der Kollektor des ersten Transistors (T16) im dritten Differenzverstärker mit dem Bezugspotential (V$_{CC}$) verbunden ist und seine Basis auf dem zweiten Referenzpotential (V$_{ref2}$) liegt und wobei die Kollektoren des zweiten und dritten Transistors (T17, T18) mit je einem der Ausgänge (A,B) verbunden sind und an den Basisanschlüssen des zweiten und dritten Transistors (T17, T18) das zweite Steuersignal (R) anliegt.

## FIG 1

# FIG 2

# FIG 3